# FASCICULE DE BREVET EUROPEEN

(11) **EP 0 461 021 B1**
(45) Date de publication et mention de la délivrance du brevet: **28.12.1994**
(21) Numéro de dépôt: 91401452.7
(22) Date de dépôt: 04.06.1991
(51) Int. Cl.: H05K 13/06

(54) **Système pour la réalisation dans un plan d'une pièce de câblage**
Vorrichtung zur Erstellung einer Verdrahtung in einer Ebene
Device for the implementation of a wiring in a plane

(30) Priorité: 06.06.1990 FR 9007013
(43) Date de publication de la demande: 11.12.1991
(73) Titulaire: EUROCOPTER FRANCE, F-13725 Marignane Cédex (FR)
(72) Inventeur: Cerda, Léon Germain, Jas Neuf, F-13620 Carry le Rouet (FR)
(74) Mandataire: Bonnetat, Christian

(56) Documents cités:
- EP-A- 0 382 605
- DE-B- 1 206 503
- US-A- 4 483 373
- US-A- 4 867 207

## Description

La présente invention concerne un système pour la réalisation dans un plan d'une pièce de câblage comportant une pluralité de conducteurs dont chacun doit suivre un cheminement prédéterminé.

L'invention s'applique, plus particulièrement quoique non exclusivement, à la réalisation de pièces de câblage pour aéronefs, notamment des hélicoptères, dans lesquels lesdites pièces sont très complexes et variées pour s'adapter aux différentes missions que doivent effectuer lesdits aéronefs.

Avant d'installer lesdites pièces de câblage, par exemple dans un aéronef qu'elles doivent équiper, il est nécessaire de mettre en forme lesdites pièces, conformément à l'agencement interne de l'aéronef, sur de longues tables (jusqu'à une dizaine de mètres de longueur), chaque conducteur s'étendant, sur la table, entre des positions d'entrée et de sortie spécifiques, en suivant un cheminement prédéterminé.

De façon classique, le système pour la réalisation d'une telle pièce de câblage comprend ainsi un support plan pourvu d'une pluralité de trous, et des pions destinés à coopérer avec lesdits trous afin de former ledit cheminement prédéterminé, lesdits pions faisant alors saillie par rapport à la face de travail dudit support plan et servant d'organes de maintien pour chacun desdits conducteurs.

Pour mettre en place ledit cheminement prédéterminé de chacun des conducteurs, l'opérateur, après avoir identifié la pièce de câblage à constituer, doit disposer, manuellement, des pions dans des trous déterminés du support plan, de façon à former ainsi le support de cheminement de chacun des conducteurs. Un telle mise en place manuelle des pions pour chaque conducteur est une opération répétitive fastidieuse qui prend du temps, et des erreurs sont inévitables.

DE US-A-4 867 207 est connu un système dans lequel des pions sont montés individuellement coulissants dans des puits prévus dans un support plan, des manchons coulissants polarisés par des ressorts étant disposés entre les pions et les puits de telle sorte que, par dépression du pion, celui-ci soit verrouillé alors que la dépression du manchon provoque le déverrouillage du pion et résulte en une position saillante du pion sous l'action d'un ressort. Ledit manchon coulissant est actionné par la face avant soit manuellement soit sous l'action du bras d'un robot programmable.

La présente invention a pour but d'éviter ces inconvénients, et concerne un système pour la réalisation dans un plan d'une pièce de câblage, grâce auquel il n'est plus nécessaire d'effectuer, manuellement, la mise en place des pions.

A cet effet, le système du type indiqué ci-dessus est remarquable, selon l'invention, en ce que :
- d'une part, chaque pion est monté coulissant à l'intérieur d'un tel trou et peut occuper, soit une position rétractée pour laquelle il est complètement rentré à l'intérieur du trou correspondant, soit une position saillante pour laquelle il fait saillie, hors dudit trou, par rapport à ladite face de travail ; et
- d'autre part, ledit système comporte :
   . des moyens d'actionnement volontaire pour faire passer lesdits pions, individuellement, de leur position rétractée à leur position saillante ;
   . des moyens de verrouillage pour maintenir lesdits pions dans leur position saillante ;
   . des moyens de déverrouillage desdits pions lorsqu'ils sont en position saillante ; et
   . des moyens de rétraction pour ramener automatiquement lesdits pions déverrouillés de leur position saillante à leur position rétractée.

Ainsi, pour former le support de cheminement des conducteurs d'une pièce de câblage déterminée, à l'introduction, dans le système, de la référence de ladite pièce de câblage par l'opérateur, ledit système fera passer les pions correspondants de leur position rétractée à leur position saillante, ce qui supprime la nécessité, pour l'opérateur, de disposer manuellement les pions sur le support plan.

Avantageusement, ledit support plan présente une épaisseur telle que, en position rétractée, lesdits pions sont entièrement logés dans l'épaisseur dudit support plan, sans faire saillie par rapport à la face arrière, opposée à ladite face de travail, dudit support plan.

Selon l'invention, chaque pion est accessible à 'travers la face arrière dudit support plan, et lesdits moyens d'actionnement volontaire comportent un poussoir commandable, disposé du côté de ladite face arrière, et déplaçable orthogonalement audit support plan.

De préférence, ledit poussoir commandable peut être monté sur un mécanisme à mouvements croisés X,Y disposé du côté de ladite face arrière dudit support plan.

Selon une autre caractéristique avantageuse de l'invention, lesdits moyens de verrouillage comportent, d'une part, une plaque incorporée audit support plan et s'étendant parallèlement à celui-ci, qui est percée d'orifices en concordance avec les trous dudit support plan et, d'autre part, des ergots de verrouillage prévus sur lesdits pions, lesdits ergots de verrouillage pouvant traverser élastiquement lesdits orifices lorsque lesdits pions passent de leur position rétractée à leur position saillante, mais lesdits ergots coopérant avec lesdits orifices pour verrouiller lesdits pions en position saillante en les empêchant de revenir spontanément à leur position rétractée.

De préférence, lesdits moyens de déverrouillage comportent des élargissements desdits orifices pratiqués dans ladite plaque, élargissements à travers lesquels lesdits ergots de verrouillage peuvent librement passer lorsque, lesdits pions étant en position saillante, ils sont ramenés vers leur position rétractée par l'action desdits moyens de rétraction, et ladite plaque est mobile dans son plan de façon à amener, à l'aplomb desdits ergots de verrouillage, soit lesdits orifices, soit lesdits élargissements.

En particulier, ladite plaque peut occuper spontanément une position d'équilibre pour laquelle lesdits orifices sont à l'aplomb desdits ergots de verrouillage desdits pions, et peut occuper une position commandée pour laquelle lesdits élargissements se trouvent à l'aplomb desdits ergots de verrouillage.

Avantageusement, lesdits moyens de rétraction sont constitués par des ressorts prenant appui, d'une part, sur lesdits pions et, d'autre part, sur la paroi des trous correspondants.

Par ailleurs, lesdits ergots de verrouillage peuvent être constitués par des coulisseaux transversaux auxdits pions, chargés par ressort, ou par des languettes élastiques, saillant latéralement par rapport auxdits pions.

Selon encore d'autres caractéristiques avantageuses de l'invention, des premiers moyens de butée sont prévus pour définir la position desdits pions en position saillante par rapport à ladite plaque et des seconds moyens de butée sont prévus pour définir la position desdits pions en position rétractée par rapport auxdits trous.

En outre, comme cela est connu par EP-A- 0 382 605 de la même demanderesse, le système peut comporter une unité de traitement d'informations, telle qu'un micro-ordinateur, comprenant des moyens de mémoire des informations relatives aux cheminements des différents conducteurs de la pièce de câblage, et reliée, d'une part, à des moyens d'identification d'un conducteur déterminé et, d'autre part, à un générateur d'un faisceau de lumière cohérente, pour lequel ledit support plan joue le rôle d'écran et qui est susceptible de balayer ledit support plan de façon à afficher, sur celui-ci, le tracé lumineux du cheminement dudit conducteur déterminé. Dans ce cas, selon l'invention, ladite unité de traitement d'informations commande également le déplacement de pions déterminés, correspondant au cheminement des différents conducteurs d'une pièce de câblage, de leur position rétractée à leur position saillante, par l'intermédiaire desdits moyens d'actionnement volontaire.

Les figures du dessin annexé feront bien comprendre comment l'invention peut être réalisée. Sur ces figures, des références identiques désignent des éléments semblables.

La figure 1 est une vue schématique en perspective, avec arrachement, d'un exemple de réalisation du système selon l'invention.

Les figures 2 et 3 montrent un pion en position saillante et en position rétractée, respectivement.

La figure 4 est un détail, en vue de dessus, de la plaque incorporée dans le support plan.

La figure 5 est une coupe longitudinale d'un premier exemple de réalisation d'un pion.

La figure 6 est la vue selon la ligne VI-VI de la figure 5.

La figure 7 est une coupe longitudinale d'un second exemple de réalisation d'un pion.

La figure 8 est la vue selon la ligne VIII-VIII de la figure 7.

La figure 9 est un schéma d'un mode de réalisation particulier de l'invention, incorporant un micro-ordinateur de commande.

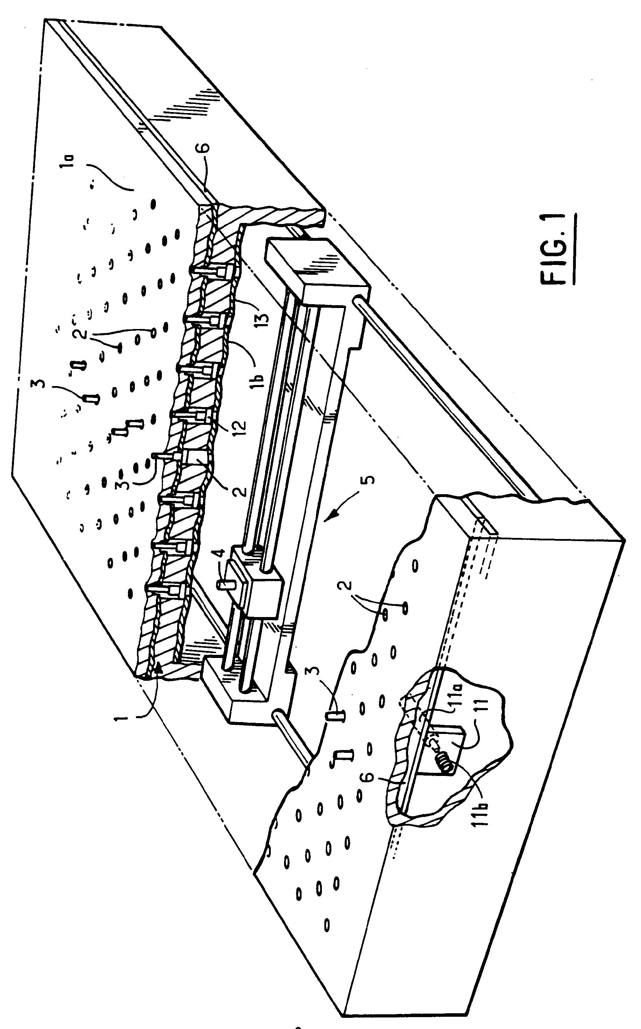

En se référant à la figure 1, le système pour la réalisation dans un plan d'une pièce de câblage comprend un support plan 1 pourvu d'une pluralité de trous 2, agencés par exemple en quinconce, et des pions 3 destinés à coopérer avec les trous 2 afin de former le cheminement d'un conducteur déterminé de la pièce de câblage. Comme déjà indiqué, les pions 3 font alors saillie par rapport à la face de travail la du support plan 1 et servent d'organes de maintien pour chacun des conducteurs à mettre en place.

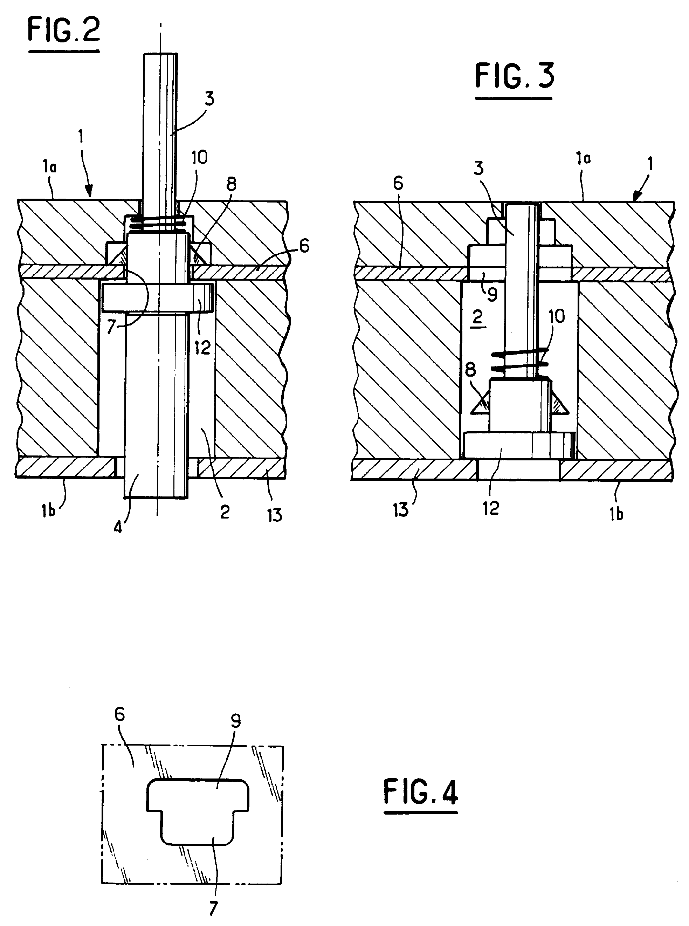

Chaque pion 3 est monté coulissant à l'intérieur d'un trou 2, et peut occuper, comme on peut mieux le voir sur les figures 2 et 3, soit une position rétractée pour laquelle il est complètement rentré à l'intérieur du trou 2, soit une position saillante pour laquelle il fait saillie, hors du trou 2, par rapport à la face de travail 1a. On remarquera que le support plan 1 présente une épaisseur telle que, en position rétractée, les pions 3 sont entièrement logés dans l'épaisseur du support plan, sans faire saillie par rapport à la face arrière 1b, opposée à la face de travail la, du support plan 1.

Chaque pion 3 est accessible à travers la face arrière 1b du support plan 1 et, pour faire passer les pions 3, individuellement, de leur position rétractée à leur position saillante, le système comporte un poussoir commandable 4, disposé du côté de la face arrière 1b, et déplaçable orthogonalement au support plan 1. Le poussoir 4 est monté sur un mécanisme à mouvements croisés X,Y 5, disposé de même du côté de la face arrière 1b du support plan 1.

Par ailleurs, pour maintenir les pions 3 en position saillante, on prévoit des moyens de verrouillage comportant, d'une part, une plaque 6 incorporée au support plan 1 et s'étendant parallèlement à celui-ci, qui est percée d'orifices 7 en concordance avec les trous 2 du support plan 1 et, d'autre part, des ergots de verrouillage 8 prévus sur lesdits pions 3, lesdits ergots de verrouillage pouvant traverser élastiquement les orifices 7 lorsque les pions 3 passent de leur position rétractée à leur position saillante, mais les ergots 8 coopérant avec les orifices 7 pour verrouiller les pions 3 en position saillante en les empêchant de revenir spontanément à leur position rétractée.

Pour déverrouiller les pions 3, la plaque 6 comporte des élargissements 9 des orifices 7 (figure 4), à travers lesquels les ergots de verrouillage 8 peuvent librement passer lorsque, les pions 3 étant en position saillante, ils sont ramenés vers leur position rétractée par l'action de ressorts 10 prenant appui, d'une part, sur les pions 3 et, d'autre part, sur la paroi des trous 2 correspondants. Par ailleurs, la plaque 6 est mobile dans son plan de façon à amener, à l'aplomb des ergots de verrouillage 8, soit les orifices 7, soit les élargissements 9, et occupe spontanément une position d'équilibre pour laquelle les orifices 7 sont à l'aplomb des ergots de verrouillage 8 des pions 3, et peut occuper une position commandée pour laquelle les élargissements 9 se trouvent à l'aplomb des ergots de verrouillage 8. Pour cela, la plaque 6 présente une butée 11 dont le déplacement, entraînant celui de la plaque 6, peut être commandé, par exemple, par un vérin (11a), et qui est soumise à l'action d'un ressort de rappel 11b.

Pour définir les positions des pions 3 en position saillante par rapport à la plaque 6, on prévoit, à la base de chaque pion 3, un épaulement 12 venant en butée contre la plaque 6 en position saillante du pion. Par ailleurs, pour définir la position des pions 3 en position rétractée par rapport aux trous 2, l'épaulement 12, dans cette position rétractée, viendra en butée contre une plaque 13 dont la face libre constitue la face arrière 1b du support plan 1.

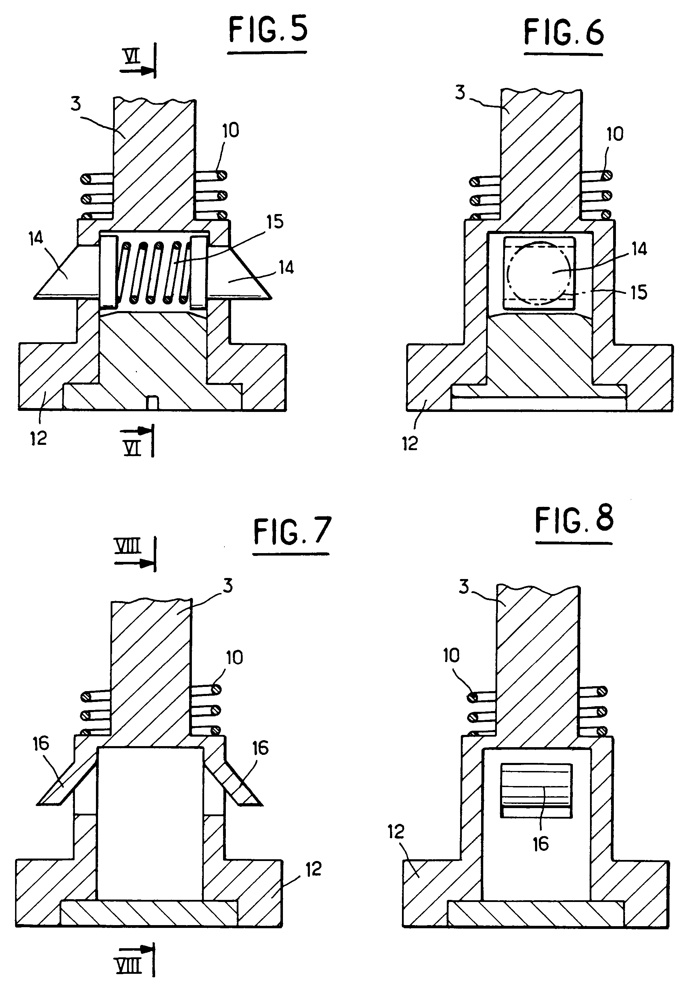

En se référant aux figures 5 et 6, dans un premier exemple de réalisation, les ergots de verrouillage sont constitués par des coulisseaux 14 transversaux au pion 3, chargés par un ressort 15, logé dans le corps du pion 3. En se référant aux figures 7 et 8, dans un second exemple de réalisation, les ergots de verrouillage sont constitués par des languettes élastiques 16, saillant latéralement par rapport au pion 3.

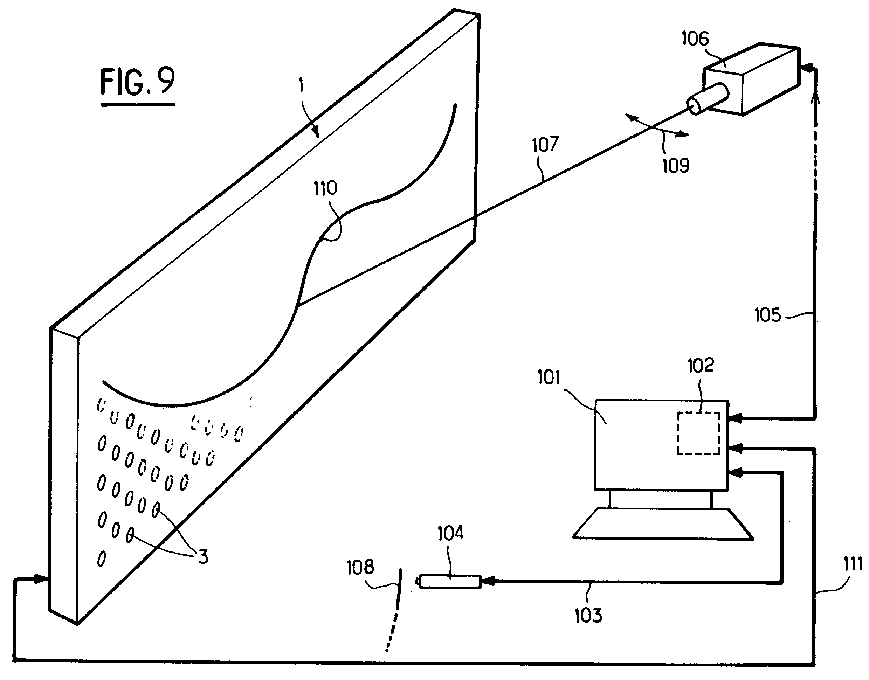

Dans un mode de réalisation particulier illustré par la figure 9, le système, comme cela est décrit en détail dans EP-A- 0 382 605, comprend un micro-ordinateur 101, comportant une mémoire 102 des informations relatives aux cheminements des différents conducteurs de la pièce de câblage, relié, par une liaison 103, à un lecteur de codes à barres 104 permettant l'identification de chacun des conducteurs de ladite pièce et, par une liaison 105, à un générateur 106 susceptible d'émettre un faisceau laser 107 de faible puissance.

Un conducteur déterminé 108 ayant été identifié grâce au lecteur 104, conducteur pour lequel les informations concernant son cheminement spécifique sont stockées dans la mémoire 102, le processeur du micro-ordinateur 101 est adapté pour piloter le générateur 106 de sorte que le faisceau laser 107 balaye (double flèche 109) le support plan 1 de façon à afficher, sur ledit support jouant le rôle d'écran, le tracé lumineux 110 du cheminement dudit conducteur. La vitesse de balayage du faisceau laser 107 est suffisamment grande pour obtenir une persistance optique dudit tracé 110.

Selon un mode préféré de l'invention, le micro-ordinateur 1 commande également le déplacement de pions 3 déterminés, correspondant au cheminement des différents conducteurs de la pièce de câblage identifiée, de leur position rétractée à leur position saillante, par l'intermédiaire du poussoir commandable 4, la liaison 111 reliant le micro-ordinateur 1 aux moteurs (non représentés) du mécanisme à mouvements croisés X,Y 5, et au moteur (non représenté) permettant de déplacer le poussoir 4 selon l'axe Z, par l'intermédiaire d'une interface appropriée.

## Revendications

1. Système pour la réalisation dans un plan d'une pièce de câblage comportant une pluralité de conducteurs dont chacun doit suivre un cheminement prédéterminé, ledit système comprenant un support plan pourvu d'une pluralité de trous, et des pions destinés à coopérer avec lesdits trous afin de former ledit cheminement prédéterminé, lesdits pions faisant alors saillie par rapport à la face de travail dudit support plan et servant d'organes de maintien pour chacun desdits conducteurs, chaque pion (3) étant monté coulissant à l'intérieur d'un tel trou (2) et pouvant occuper, soit une position rétractée pour laquelle il est complètement rentré à l'intérieur du trou (2) correspondant, soit une position saillante pour laquelle il fait saillie, hors dudit trou (2), par rapport à ladite face de travail (1a) et ledit système comportant :
- des moyens d'actionnement volontaire (4) pour faire passer lesdits pions (3), individuellement, de leur position rétractée à leur position saillante ;
- des moyens de verrouillage (6,8) pour maintenir lesdits pions (3) dans leur position saillante ;
- des moyens de déverrouillage (9) desdits pions (3) lorsqu'ils sont en position saillante ; et
- des moyens de rétraction (10) pour ramener automatiquement lesdits pions (3) déverrouillés de leur position saillante à leur position rétractée,
chaque pion (3) étant accessible à travers la face arrière (1b) dudit support plan (1), et lesdits moyens d'actionnement volontaire comportant un poussoir commandable (4), disposé du côté de ladite face arrière (1b), et déplaçable orthogonalement audit support plan (1).

2. Système selon la revendication 1,
caractérisé en ce que ledit support plan (1) présente une épaisseur telle que, en position rétractée, lesdits pions (3) sont entièrement logés dans l'épaisseur dudit support plan (1), sans faire saillie par rapport à la face arrière (1b), opposée à ladite face de travail (1a), dudit support plan (1).

3. Système selon la revendication 1,
caractérisé en ce que ledit poussoir commandable (4) est monté sur un mécanisme (5) à mouvements croisés X,Y disposé du côté de ladite face arrière (1b) dudit support plan (1).

4. Système selon l'une quelconque des revendications 1 à 3,
caractérisé en ce que lesdits moyens de verrouillage comportent, d'une part, une plaque (6) incorporée audit support plan (1) et s'étendant parallèlement à celui-ci, qui est percée d'orifices (7) en concordance avec les trous (2) dudit support plan (1) et, d'autre part, des ergots de verrouillage (8) prévus sur lesdits pions (3), lesdits ergots de verrouillage (8) pouvant traverser élastiquement lesdits orifices (7) lorsque lesdits pions (3) passent de leur position rétractée à leur position saillante, mais lesdits ergots (8) coopérant avec lesdits orifices (7) pour verrouiller lesdits pions (3) en position saillante en les empêchant de revenir spontanément à leur position rétractée.

5. Système selon la revendication 4,
caractérisé en ce que lesdits moyens de déverrouillage comportent des élargissements (9) desdits orifices (7) pratiqués dans ladite plaque (6), élargissements à travers lesquels lesdits ergots de verrouillage (8) peuvent librement passer lorsque, lesdits pions (3) étant en position saillante, ils sont ramenés vers leur position rétractée par l'action desdits moyens de rétraction (10), et en ce que ladite plaque (6) est mobile dans son plan de façon à amener, à l'aplomb desdits ergots de verrouillage (8), soit lesdits orifices (7), soit lesdits élargissements (9).

6. Système selon la revendication 5,
caractérisé en ce que ladite plaque (6) occupe spontanément une position d'équilibre pour laquelle lesdits orifices (7) sont à l'aplomb desdits ergots de verrouillage (8) desdits pions (3), et peut occuper une position commandée pour laquelle lesdits élargissements (9) se trouvent à l'aplomb desdits ergots de verrouillage (8).

7. Système selon l'une quelconque des revendications 1 à 6,
caractérisé en ce que lesdits moyens de rétraction sont constitués par des ressorts (10) prenant appui, d'une part, sur lesdits pions (3) et, d'autre part, sur la paroi des trous (2) correspondants.

8. Système selon l'une quelconque des revendications 4 à 7,
caractérisé en ce que lesdits ergots de verrouillage sont constitués par des coulisseaux (14) transversaux auxdits pions (3), chargés par ressort (15).

9. Système selon l'une quelconque des revendications 4 à 7,
caractérisé en ce que lesdits ergots de verrouillage sont constitués par des languettes élastiques (16), saillant latéralement par rapport auxdits pions (3).

10. Système selon l'une quelconque des revendications 4 à 9,
caractérisé en ce que des premiers moyens de butée (12) sont prévus pour définir la position desdits pions (3) en position saillante par rapport à ladite plaque (6).

11. Système selon l'une quelconque des revendications 1 à 10,
caractérisé en ce que des seconds moyens de butée (13) sont prévus pour définir la position desdits pions (3) en position rétractée par rapport auxdits trous (2).

12. Système selon l'une quelconque des revendications 1 à 11, comportant une unité de traitement d'informations, telle qu'un micro-ordinateur, comprenant des moyens de mémoire des informations relatives aux cheminements des différents conducteurs de la pièce de câblage, et reliée à des moyens d'identification de la pièce de câblage,
caractérisé en ce que ladite unité de traitement d'informations (101) commande le déplacement de pions déterminés (3), correspondant au cheminement desdits. conducteurs (108), de leur position rétractée à leur position saillante, par l'intermédiaire desdits moyens d'actionnement volontaire.

## Patentansprüche

1. System, um ein Verkabelungsteil mit einer Vielzahl von Leitern, die jeweils einen bestimmten Verlauf haben müssen, in einer Ebene zu verwirklichen, wobei das System eine ebene Unterlage mit einer Vielzahl von Bohrungen sowie Stifte hat, die zur Festlegung des vorbestimmten Verlaufs mit den Bohrungen zusammenwirken, wobei die Stifte dann über die Arbeitsfläche der ebenen Unterlage überstehen und als Halteorgan für jeden der Leiter dienen, jeder Stift (3) innerhalb einer solchen Bohrung (2) beweglich ist und entweder eine eingezogene Stellung, in der er sich völlig innerhalb der entsprechenden Bohrung (2) befindet, oder eine überstehende Stellung einnehmen kann, in der er außerhalb von Bohrung (2) über die Arbeitsfläche (1a) übersteht, und das System umfaßt:
- Mittel zur gewollten Betätigung (4), um die Stifte (3) einzeln aus ihrer eingezogenen Stellung in die überstehende Stellung zu verschieben;
- Verriegelungsmittel (6,8), um die Stifte (3) in ihrer überstehenden Stellung zu blockieren;
- Mittel zur Entriegelung (9) der Stifte (3), wenn diese sich in der überstehenden Stellung befinden; und
- Einzugsmittel (10), um die entriegelten Stifte (3) aus ihrer überstehenden Stellung in die eingezogene Stellung zu verschieben,
wobei jeder Stift (3) über die Rückseite (1b) der ebenen Unterlage (1) zugänglich ist und die Mittel zur gewollten Betätigung einen Bedienstößel (4) haben, der auf der Rückseite (1b) angeordnet und senkrecht zur ebenen Unterlage (1) verschiebbar ist.

2. System nach Anspruch 1,
dadurch gekennnzeichnet, daß die ebene Unterlage (1) eine solche Dicke hat, daß sich die Stifte (3) in eingezogener Stellung vollständig innerhalb der Dicke der ebenen Unterlage (1) befinden und nicht an der der Arbeitsfläche (1a) entgegengesetzten Rückseite (1b) der ebenen Unterlage (1) überstehen.

3. System nach Anspruch 1,
dadurch gekennzeichnet, daß der Bedienstößel (4) an einer Kreuzvorrichtung (5) mit X-Y-Bewegungen an der Rückseite (1b) der ebenen Unterlage (1) angebracht ist.

4. System nach einem der Ansprüche 1 bis 3,
dadurch gekennzeichnet, daß die Verriegelungsmittel einerseits eine in die ebene Unterlage (1) parallel zu dieser eingefügte Platte (6) mit Öffnungen (7) entsprechend den Bohrungen (2) in der ebenen Unterlage (1) und andererseits an den Stiften (3) Verriegelungsnasen (8) haben, wobei die Verriegelungsnasen (8) federnd die Öffnungen (7) passieren können, wenn die Stifte (3) aus ihrer eingezogenen Stellung in die überstehende Stellung übergehen, die Nasen (8) jedoch mit den Öffnungen (7) zusammenwirken und die Stifte (3) in der überstehenden Stellung verriegeln, so daß sie nicht spontan in die eingezogene Stellung zurückkehren können.

5. System nach Anspruch 4,
dadurch gekennzeichnet, daß die Entriegelungsmittel in den Öffnungen (7) Erweiterungen (9) haben, die an der Platte (6) angebracht sind und von den Verriegelungsnasen (8) ungehindert passiert werden können, wenn die Stifte (3) aus ihrer überstehenden Stellung durch Betätigung der Einzugsmittel (10) in die eingezogene Stellung versetzt werden, und dadurch, daß die Platte (6) in ihrer Ebene beweglich ist, so daß senkrecht zu den Verriegelungsnasen (8) entweder die Öffnungen (7) oder die Erweiterungen (9) eingestellt werden können.

6. System nach Anspruch 5,
dadurch gekennzeichnet, daß die Platte (6) spontan eine Ausgleichsstellung einnimmt, in der sich die Öffnungen (7) senkrecht zu den Verriegelungsnasen (8) der Stifte (3) befinden, und eine Bedienstellung einnehmen kann, in der sich die Erweiterungen (9) senkrecht zu den Verriegelungsnasen (8) befinden.

7. System nach einem der Ansprüche 1 bis 6,
dadurch gekennzeichnet, daß die Einzugsmittel aus Federn (10) bestehen, die einerseits an den Stiften (3) und andererseits an der Wand der entsprechenden Bohrungen (2) anliegen.

8. System nach einem der Ansprüche 4 bis 7,
dadurch gekennzeichnet, daß die Verriegelungsnasen aus quer zu den Stiften (3) verlaufenden, durch eine Feder (15) belasteten Gleitstücken (14) bestehen.

9. System nach einem der Ansprüche 4 bis 7,
dadurch gekennzeichnet, daß die Verriegelungsnasen aus Federzungen (16) bestehen, die seitlich über die Stifte (3) überstehen.

10. System nach einem der Ansprüche 4 bis 9,
dadurch gekennzeichnet, daß erste Anschlagmittel (12) vorgesehen sind, durch die die Position der Stifte (3) in der überstehenden Stellung gegenüber Platte (6) bestimmt wird.

11. System nach einem der Ansprüche 1 bis 10,
dadurch gekennzeichnet, daß zweite Anschlagmittel (13) vorgesehen sind, durch die die Position der Stifte (3) in der eingezogenen Stellung gegenüber den Bohrungen (2) bestimmt wird.

12. System nach einem der Ansprüche 1 bis 11 mit einer Informationsverarbeitungseinheit, beispielsweise einem Mikrocomputer, mit Mitteln zur Speicherung der Informationen für den Verlauf der verschiedenen Leiter des Verkabelungsteils, die mit Identifizierungsmitteln des Verkabelungsteils verbunden ist,
dadurch gekennzeichnet, daß die Informationsverarbeitungseinheit (101) die Bewegung bestimmter Stifte (3) aus ihrer eingezogenen Stellung in ihre überstehende Stellung entsprechend dem Verlauf der Leiter (108) durch Mittel zur gewollten Betätigung steuert.

## Claims

1. System for producing, in a plane, a wiring harness including a plurality of conductors each of which has to follow a predetermined routing, the said system comprising a flat support provided with a plurality of holes, and pins intended to interact with the said holes so as to form the said predetermined routing, the said pins then projecting with respect to the working face of the said flat support and serving as holding elements for each of the said conductors, each pin (3) being mounted so as to slide within such a hole (2) and being able to occupy either a retracted position for which it is completely withdrawn within the corresponding hole (2), or a projecting position for which it projects out of the said hole (2), with respect to the said working face (la) and the said system including:
- intentional actuation means (4) for making the said pins (3) pass individually from their retracted position to their projecting position;
- latching means (6, 8) for keeping the said pins (3) in their projecting position;
- means (9) for unlatching the said pins (3) when they are in projecting position; and
- retraction means (10) for automatically bringing the said unlatched pins (3) back from their projecting position to their retracted position,
each pin (3) being accessible through the rear face (1b) of the said flat support (1), and the said intentional actuating means including a controllable pusher (4), arranged on the said rear face side (1b), and movable orthogonally to the said flat support (1).

2. System according to Claim 1, characterized in that the said flat support (1) has a thickness such that, in retracted position, the said pins (3) are entirely housed in the thickness of the said flat support (1), without projecting with respect to the rear face (1b), opposite the said working face (1a) of the said flat support (1).

3. System according to Claim 1, characterized in that the said controllable pusher (4) is mounted on a mechanism (5) with crossed X, Y movements, arranged on the said rear face side (1b) of the said flat support (1).

4. System according to any one of Claims 1 to 3, characterized in that the said latching means include, on the one hand, a plate (6) incorporated into the said flat support (1) and extending parallel to the latter, which is pierced with orifices (7) in alignment with the holes (2) of the said flat support (1) and, on the other hand, latching studs. (8) provided on the said pins (3), the said latching studs (8) being capable of passing elastically through the said orifices (7) when the said pins (3) pass from their retracted position to their projecting position, but the said studs (8) interacting with the said orifices (7) so as to latch the said pins (3) in projecting position, preventing them coming spontaneously back to their retracted position.

5. System according to Claim 4, characterized in that the said unlatching means include widenings (9) of the said orifices (7) formed in the said plate (6), widenings through which the said latching studs (8) can pass freely when, with the said pins (3) in projecting position, they are brought back to their retracted position by the action of the said retraction means (10) and in that the said plate (6) is movable in its plane in such a way as to bring either the said orifices (7) or the said widenings (9) vertically in line with the said latching studs (8).

6. System according to Claim 5, characterized in that the said plate (6) spontaneously takes up an equilibrium position for which the said orifices (7) are vertically in line with the said latching studs (8) of the said pins (3), and can take up a controlled position for which the said widenings (9) are vertically in line with the said latching studs (8).

7. System according to any one of Claims 1 to 6, characterized in that the said retraction means consist of springs (10) bearing, on the one hand, on the said pins (3) and, on the other hand, on the wall of the corresponding holes (2).

8. System according to any one of Claims 4 to 7, characterized in that the said latching studs consist of sliders (14) transverse to the said pins (3), loaded by a spring (15).

9. System according to any one of Claims 4 to 7, characterized in that the said latching studs consist of elastic tongues (16), projecting laterally with respect to the said pins (3).

10. System according to any one of Claims 4 to 9, characterized in that first stop means (12) are provided in order to define the position of the said pins (3) in projecting position with respect to the said plate (6).

11. System according to any one of Claims 1 to 10, characterized in that second stop means (13) are provided in order to define the position of the said pins (3) in retracted position with respect to the said holes (2).

12. System according to any one of Claims 1 to 11, including an information processing unit, such as a microcomputer, comprising memory means for the information relating to the routings of the various conductors of the wiring harness, and linked to means of identifying the wiring harness, characterized in that the said information processing unit (101) controls the movement of defined pins (3), corresponding to the routing of the said conductors (108), from their retracted position to their projecting position, by way of the said intentional actuation means.
